# EUROPEAN PATENT SPECIFICATION

(11) **EP 1 868 097 B1**
(45) Date of publication and mention of the grant of the patent: **28.04.2010**
(21) Application number: 07252283.2
(22) Date of filing: 06.06.2007
(51) Int. Cl.: G06F 11/14, G06F 12/02, G11C 11/22

(54) **Integrated circuit chip, data reading method and data writing method**
Chip für eine integrierte Schaltung, Datenleseverfahren und Datenschreibverfahren
Puce de circuit intégré, procédé de lecture de données et procédé d'écriture de données

(30) Priority: 16.06.2006 JP 2006167300
(43) Date of publication of application: 19.12.2007
(73) Proprietor: Sony Corporation, Minato-ku Tokyo 108-0075 (JP)
(72) Inventor: Teruyama, Katsuyuki, Tokyo 108-0075 (JP)
(74) Representative: Mills, Julia

(56) References cited:
- EP-A- 1 420 345
- WO-A-2005/050657
- US-A1- 2004 085 849
- US-A1- 2004 221 130
- US-B1- 6 282 624

## Description

The present invention contains subject matter related to Japanese Patent Application JP 2006-167300 filed in the Japanese Patent Office on June 16, 2006.

The present invention relates to the field of integrated circuit (IC) chips, data reading methods, and data writing methods, and illustrative embodiments, to an integrated circuit (IC) chip, a data reading method, and a data writing method for duplexing data to form a duplexed data set and holding the duplexed data set in order to deal with a case where power interruption occurs during data updating.

In recent years, various services using IC cards have been developed. An IC card includes a nonvolatile memory (NVM) for holding data. In order to deal with a case where power interruption occurs during data writing, data is duplexed to form a duplexed data set and the duplexed data set is held in the NVM. A memory management method for maintaining the consistency of data even when power interruption occurs during data writing is disclosed in Japanese Unexamined Patent Application Publication No. 11-25003 "Information Processing Method and Information Processing Apparatus".

When an NVM of a type that performs deletion and rewriting in units of pages, such as an electrically erasable programmable read-only memory (EEPROM), which is assumed in the related art described above, is used, at the time of data update, data to be updated is transferred to a random-access memory (RAM) and then data that has been updated in the RAM is rewritten to the NVM. Thus, in the known method, complicated processing is performed for memory management to deal with power interruption during data writing.

WO 2005/050657 discloses an integrated circuit chip having a non-volatile, rewritable memory employing passive matrix addressing according to the preamble of claim 1.

It is desirable to provide a novel and improved integrated circuit chip, data reading method, and data writing method capable of simplifying processing for memory management to maintain the consistency of data even when power interruption occurs during data writing.

According to an embodiment of the present invention, an integrated circuit chip according to claim 1 is provided. The integrated circuit chip includes a memory storing a duplexed data set and capable of data rewriting (reading and writing). The memory is a nonvolatile memory capable of performing data rewriting in units of bytes without necessity of data deletion in units of pages.

In the related art, when data stored in an IC card is updated, it is necessary for an NVM, such as an EEPROM, to perform deletion and rewriting in units of pages. Thus, after a certain amount of data in the NVM is copied to a RAM (volatile memory) and the data in the RAM is updated, a page of the NVM is deleted and rewriting is performed. In contrast, in an embodiment of the present invention, since an NVM without necessity of deletion is used, copying to a RAM is not necessary. Thus, at the time of data update, simple processing can be performed in which an invalid side of a duplexed data set is updated and switching between the valid side and the invalid side is performed at the end.

In the integrated circuit chip, for example, the memory may be, for example, an FeRAM. The FeRAM is a type of nonvolatile memory using a ferroelectric. The ferroelectric is a dielectric capable of freely changing the direction of spontaneous polarization in a substance (a state in which an electrically positive or negative polarity in the substance is generated) by application of a voltage and maintaining the polarization direction even when no voltage is applied (a substance in which an electric charge is charged by polarization and a direct current does not flow through the substance). The FeRAM is a nonvolatile memory including such a ferroelectric serving as a storage element. The FeRAM has a configuration similar to a DRAM and is capable of performing reading and writing at a high speed, which is equal to or more than ten times the reading and writing speed of a flash memory. In addition, the FeRAM achieves a significantly higher reliability compared with a flash memory or an EEPROM.

In addition, the nonvolatile memory adopts a data structure including a duplexed root table set, each root table of the duplexed root table set holding information on the correspondence between a logical block and a physical block and a counter for broken transaction and a table switch indicating which root table of the duplexed root table set is valid or invalid. Since rewriting is performed in units of bytes, it is unnecessary to perform writing for each page (segment). Thus, a segment table can be deleted from the data structure.

In addition, the integrated circuit chip may be mounted in an IC card or a data processing apparatus, such as a cellular phone or a personal digital assistant (PDA). Various services can be developed using IC cards, cellular phones, or the like that have been widely used and that may be developed in the future.

According to another embodiment of the present invention, a data reading method for reading data from an integrated circuit chip according to claim 3 including a nonvolatile memory capable of performing rewriting in units of bytes without necessity of data deletion in units of pages and a volatile memory is provided. The nonvolatile memory includes a duplexed root table set, each root table of the duplexed root table set holding information on the correspondence between a logical block and a physical block and a counter for broken transaction, and a table switch indicating which root table of the duplexed root table set is valid or invalid. The data reading method includes the steps of starting up the integrated circuit chip, acquiring from the valid side of the duplexed root table set stored in the nonvolatile memory the position of data designated to be read and copying the acquired data to a buffer in the volatile memory, and reading the data from the volatile memory.

The step of starting up the integrated circuit chip may include the steps of checking a valid side of the duplexed root table set using the table switch and copying information on the physical block corresponding to the logical block from the valid side to the invalid side of the duplexed root table set.

The nonvolatile memory may be, for example, an FeRAM.

According to another embodiment of the present invention, a data writing method for writing data to an integrated circuit chip according to claim 6 including a nonvolatile memory capable of performing rewriting in units of bytes without necessity of data deletion in units of pages is provided. The nonvolatile memory includes a duplexed root table set, each root table of the duplexed root table set holding information on the correspondence between a logical block and a physical block and a counter for broken transaction, and a table switch indicating which root table of the duplexed root table set is valid or invalid. The data writing method includes the steps of starting up the integrated circuit chip, acquiring from the invalid side of the duplexed root table set stored in the nonvolatile memory the position of data designated to be written and updating the invalid side of the duplexed root table set so as to indicate the position at which the new data is stored, and inverting the table switch to perform switching between the valid side and the invalid side of the duplexed root table set.

The step of starting up the integrated circuit chip may include the steps of checking a valid side of the duplexed root table set using the table switch and copying information on the physical block corresponding to the logical block from the valid side to the invalid side of the duplexed root table set.

The nonvolatile memory may be, for example, an FeRAM.

As described above, processing for memory management to maintain the consistency of data even when power interruption occurs during data writing can be simplified.

The invention will now be described by way of example with reference to the accompanying drawings, throughout which like parts are referred to by like references, and in which:
Fig. 1 is an explanatory diagram of a system using an IC card;
Fig. 2 is an explanatory diagram showing the flow of a broken transaction process;
Fig. 3 is an explanatory diagram of a data structure;
Fig. 4 is an explanatory diagram showing a startup process;
Fig. 5 is an explanatory diagram showing a data reading process;
Fig. 6 is an explanatory diagram showing a data writing process;
Fig. 7 is an explanatory diagram showing a data structure of a direct-update file system;
Fig. 8 is an explanatory diagram showing a startup process;
Fig. 9 is an explanatory diagram showing a data reading process; and
Fig. 10 is an explanatory diagram showing a data writing process.

An integrated circuit (IC) chip, a data reading method, and a data writing method according to an embodiment of the present invention will be described with reference to the drawings. In the specification and drawings, elements having fundamentally the same functional configuration are referred to with the same reference numerals or symbols and redundant explanations of those elements will not be provided.

A configuration of a system using an IC card and a configuration of the IC card will first be described. Then, the flow of a broken transaction process of the IC card will be described. In addition, a data structure of tables, a startup process, a data reading process, and a data writing process in an EEPROM, which is a type of nonvolatile memory (NVM) of the IC card, will be described. Moreover, as features of this embodiment, a data structure of a table, a startup process, a data reading process, and a data writing process in a case where the NVM of the IC card is a ferroelectric random-access memory (FeRAM) will be described.

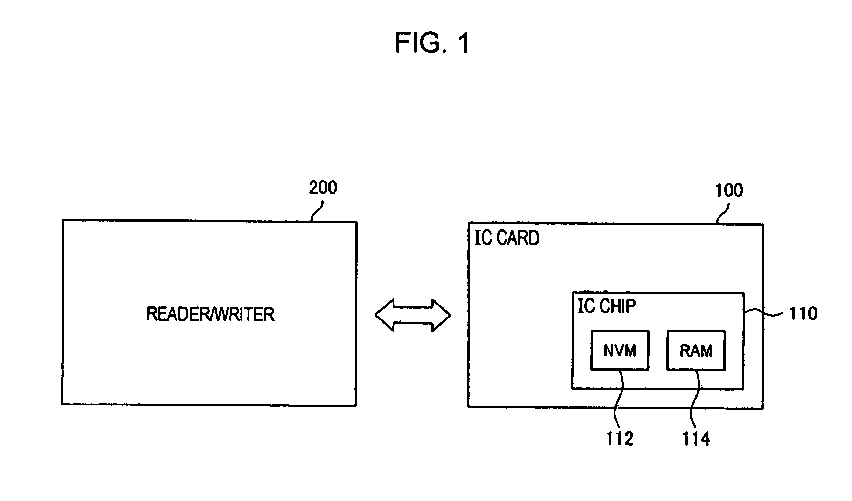

### System Configuration (Fig. 1)

Fig. 1 is an explanatory diagram showing an example of a configuration of a system using an IC card. In the example shown in Fig. 1, the system includes an IC card 100 including an IC chip 110. The system also includes a reader/writer 200 that performs reading and writing of data from and to the IC card 100 via direct communication with the IC card 100.

The IC chip 110 for holding data is provided in the IC card 100. As shown in Fig. 1, the IC chip 110 includes a nonvolatile memory (NVM) 112 capable of holding stored contents even after power is turned off and a RAM (an example of a volatile memory) 114 that erases stored contents after power is turned off. The NVM 112 holds data on various services that can be used with the IC card 100. The RAM 114 is used for temporarily holding data, for example, when data reading or data writing is performed.

The IC card 100 may be a card-type data communication apparatus. Alternatively, an IC chip having an IC card function may be contained in an information communication terminal apparatus (data processing apparatus), such as a cellular phone. In this specification, for the sake of convenience, irrespective of whether the IC card is contained in an apparatus or is configured to be connectable to or disconnectable from the apparatus, the term "IC card" may be used. In addition, the IC chip having the IC card function is provided in a portable terminal, such as a cellular phone or a personal digital assistant (PDA), or in an information processing terminal, such as a personal computer (PC), and performs data communication with an external apparatus. In this case, the IC card 100 includes an interface for allowing connection with an external apparatus as well as an interface for allowing wired or wireless connection with the reader/writer 200.

The reader/writer 200 has a function of directly communicating with the IC card 100 to read data recorded in the IC card 100 and write data to the IC card 100. The data communication between the IC card 100 and the reader/writer 200 is achieved via wireless communication based on, for example, the principle of electromagnetic induction. The reader/writer 200 is integrated with an information processing apparatus, such as a computer, or performs communication via a cable or the like. Such an information processing apparatus is controlled by a service provider. Various services using IC cards are developed.

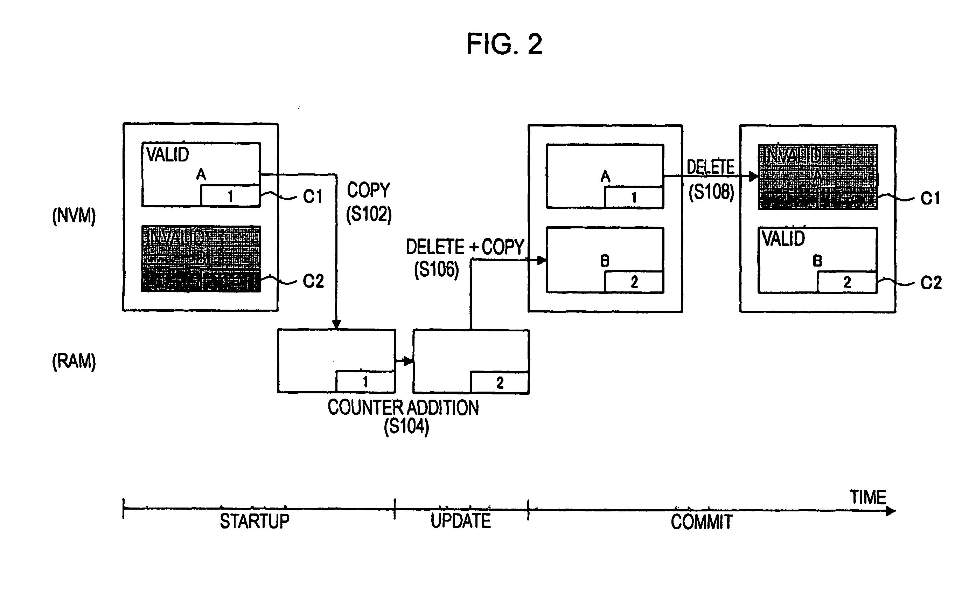

### Flow of Broken Transaction Process (Fig. 2)

A broken transaction process performed in the NVM 112 and the RAM 114 of the IC chip 110 shown in Fig. 1 will be mainly described. The term "broken transaction" means power interruption during data writing to an IC card. Fig. 2 shows a general flow of the process when a file system has a simple data structure.

First, in order to deal with broken transaction, data stored in the NVM 112 is duplexed. Referring to Fig. 2, each of data A and data B represents data for a page in the NVM 112. The data A and the data B include counters C1 and C2, respectively, to indicate which of the data A or the data B is valid. At the time of startup, the counter C1 indicates "1" and the counter C2 indicates "-". Thus, the data A is valid and the data B is invalid.

At the time of startup, the data A, which is valid, in the NVM 112 is copied to the RAM 114 (step S102). At the time of update, the data in the RAM 114 is updated, and counter addition is performed (step S104). At the time of commit, the data in the RAM 114 is copied to the invalid side B in the NVM 112. When the NVM 112 is an EEPROM, since data deletion is necessary before rewriting, the data copying is performed after the invalid data B is deleted (step S106). Then, the valid data A is deleted (step S108). In this state, the counter C1 indicates "-" and the counter C2 indicates "2". Thus, the data A is invalid and the data B is valid.

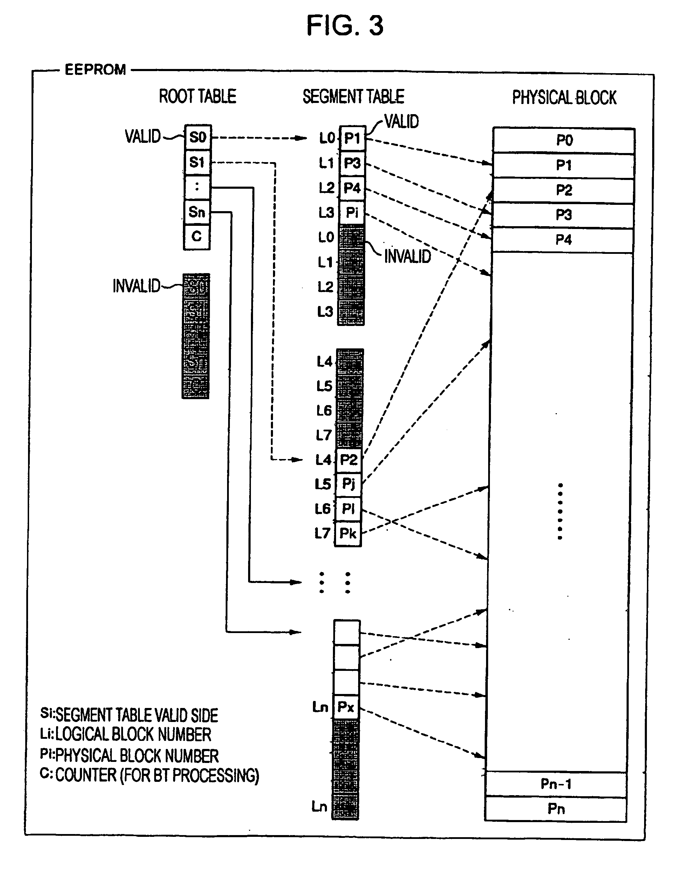

### Data Structure (Fig. 3)

Fig. 3 is an explanatory diagram showing a data structure of management tables in an EEPROM in the actual file system.

The management tables of the EEPROM are a root table and a segment table, as shown in Fig. 3. The segment table includes a correspondence list of logical blocks (Li) and physical blocks (Pi). A segment table corresponds to one page of the EEPROM, and the segment table is duplexed to form a segment table set. Information indicating which table of the duplexed segment table set is valid or invalid is held in a root table, and the root table is also duplexed to form a duplexed root table set. A root table includes information on a valid side (Si) of a segment table set. In addition, similarly to the "flow of the broken transaction process" described above, a counter C for broken transaction is held in the root table.

When a correspondence list of logical blocks and physical blocks can be contained in a page, which is a unit of rewriting of the EEPROM, requirements for dealing with broken transaction can be satisfied. However, when a page has 64 bytes, only 64 user blocks can be controlled. Thus, a plurality of segment tables are prepared, and a root table controls the plurality of segment tables.

Cyclic redundancy check (CRC) is provided for the root table and the segment tables. CRC is performed when reading from the EEPROM or writing to the EEPROM is performed.

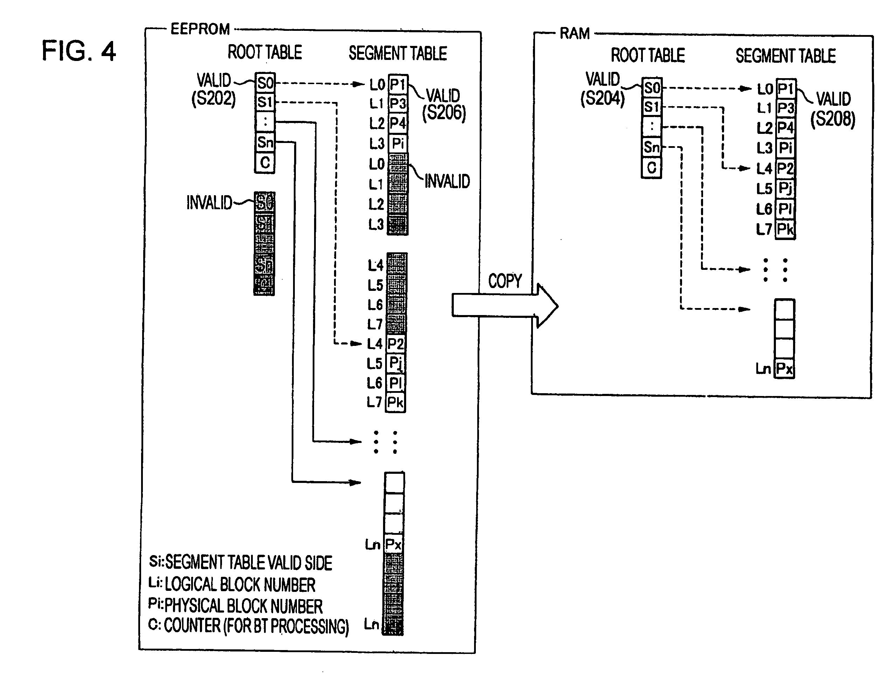

### Startup Process (Fig. 4)

Fig. 4 is an explanatory diagram showing a startup process.

First, a management table valid side in the EEPROM is copied to the RAM. When it is determined that an error has occurred in accordance with a result of CRC of a root table set, in the process for dealing with broken transaction, a valid side of the root table set is determined by performing CRC and checking counters for each table of the root table set.

As shown in Fig. 4, an unerased side of the root table set is determined to be a valid side by referring to contents of each table of the root table set in the EEPROM (step S202). The root table valid side is copied from the EEPROM to the RAM (step S204). A segment table valid side is acquired in accordance with a segment bitmap (S0, S1, ..., or Sn) in the root table in the RAM (step S206). The segment table valid side is copied from the EEPROM to the RAM (step S208). The processing of steps S202 and S204 is repeated the number of times corresponding to the number of segment tables.

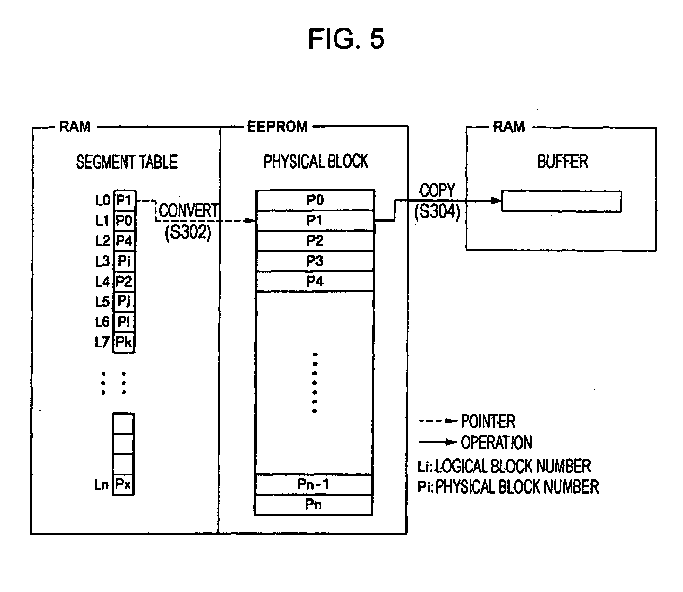

### Data Reading Process (Fig. 5)

Fig. 5 is an explanatory diagram showing a data reading process.

In the data reading process, the position of designated data is acquired from a management table in the RAM, and the data is copied from a physical block (EEPROM) to a buffer (RAM).

Referring to Fig. 5, in accordance with information in a segment table in the RAM, a designated logical block number is converted into a physical block number (step S302). Then, data is copied from a physical block in the EEPROM corresponding to the physical block number to the buffer in the RAM (step S304).

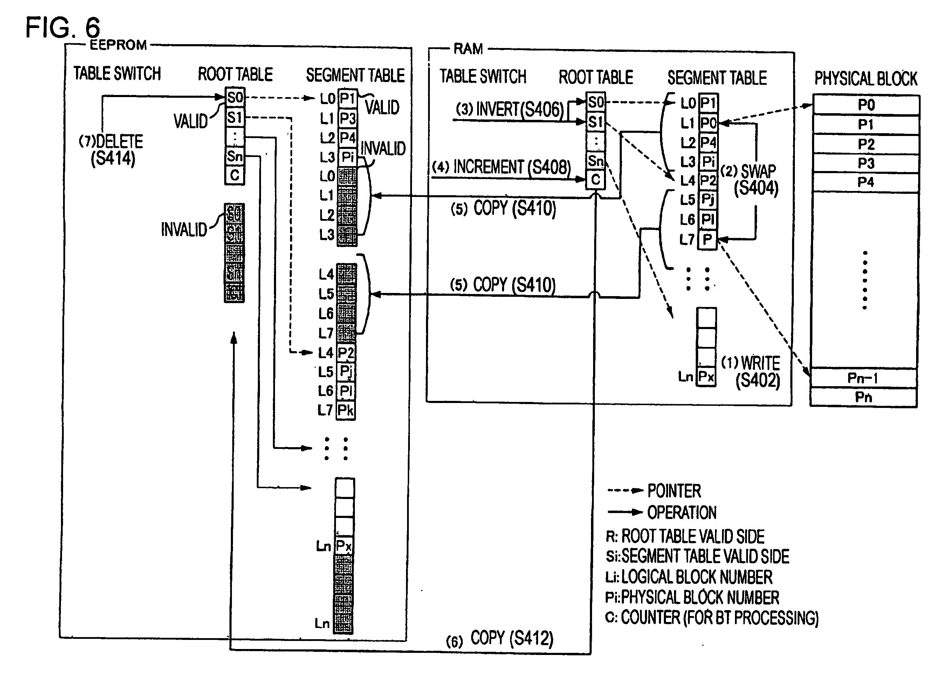

### Data Writing Process (Fig. 6)

Fig. 6 is an explanatory diagram showing a data writing process.

In the data writing process, the position of designated data is acquired from a management table in the RAM, the management table in the RAM is updated such that the position at which new data is stored is indicated, and information on the update is copied to the EEPROM. The EEPROM performs deletion before copying.

Designated data is written to a writing buffer (Pn-1 in Fig. 6) in the EEPROM (step S402). In a segment table in the RAM, an element (L7) indicating the position of the writing buffer is swapped for an element (L1) indicating the position of data to be written (step S404). Segment bitmaps in a root table in the RAM corresponding to segment tables for which the swapping has been performed are inverted (sep S406). Thus, switching between a valid side and an invalid side is performed.

A counter of the root table in the RAM is incremented (step S408). The segment table is copied from the RAM to segment table invalid sides of the EEPROM (step S410). Then, the root table is copied from the RAM to the root table invalid side of the EEPROM (step S412). Finally, the root table valid side is deleted.

Although the process to update two segment table elements has been described, when a plurality of pieces of data is written, processing of writing to a writing buffer and updating a segment table (steps S402 to S406) is repeatedly performed. Since the final writing to the EEPROM is achieved by performing rewriting and deletion of a root table, a plurality of pieces of data can be updated at the same time. In addition, since writing to the EEPROM is performed at the end of the writing process, the number of writing times can be reduced compared with a case where the EEPROM is sequentially updated.

### <File System when FeRAM is used>

A file system when an FeRAM is used, which is a feature of this embodiment, will be described. The FeRAM is a type of nonvolatile memory using a ferroelectric. The ferroelectric is a dielectric capable of freely changing the direction of spontaneous polarization in a substance (a state in which an electrically positive or negative polarity in the substance is generated) by application of a voltage and maintaining the polarization direction even when no voltage is applied (a substance in which an electric charge is charged by polarization and a direct current does not flow through the substance). The FeRAM is a nonvolatile memory including such a ferroelectric serving as a storage element. The FeRAM has a configuration similar to a DRAM and is capable of performing reading and writing at a high speed, which is equal to or more than ten times the reading and writing speed of a flash memory. In addition, the FeRAM achieves a significantly higher reliability compared with a flash memory or an EEPROM.

When an FeRAM is used as a storage memory, it is necessary to design a file system taking into consideration the restriction on a memory device of the FeRAM, similarly to a case where an EEPROM is used. That is, for data rewriting, it is necessary for an EEPROM to perform deletion and writing in units of pages. However, an FeRAM is capable of performing rewriting in units of bytes without necessity of deletion. In addition, compared with an EEPROM, data can be rewritable a larger number of times and a shorter rewrite processing time is necessary in an FeRAM. When a file system using such a nonvolatile memory that is capable of performing rewriting in units of bytes is designed, the points described below are considered.
(a) Since writing in units of bytes is possible and only a short write time is necessary, data updating in an NVM can be performed in a distributed manner in a write process, instead of being performed collectively at the end of the write process. Thus, the time necessary for the write process may be reduced.
(b) Since writing in units of bytes is possible, it is not necessary to control data in units of pages (segments). Thus, a simplification of a data structure and a reduction in the processing time may be achieved.
(c) Since writing in units of bytes is possible and the number of rewritable times is equal to or more than 108, data in an FeRAM may be directly updated without being transferred to a RAM. Thus, the amount of use of the RAM can be reduced.

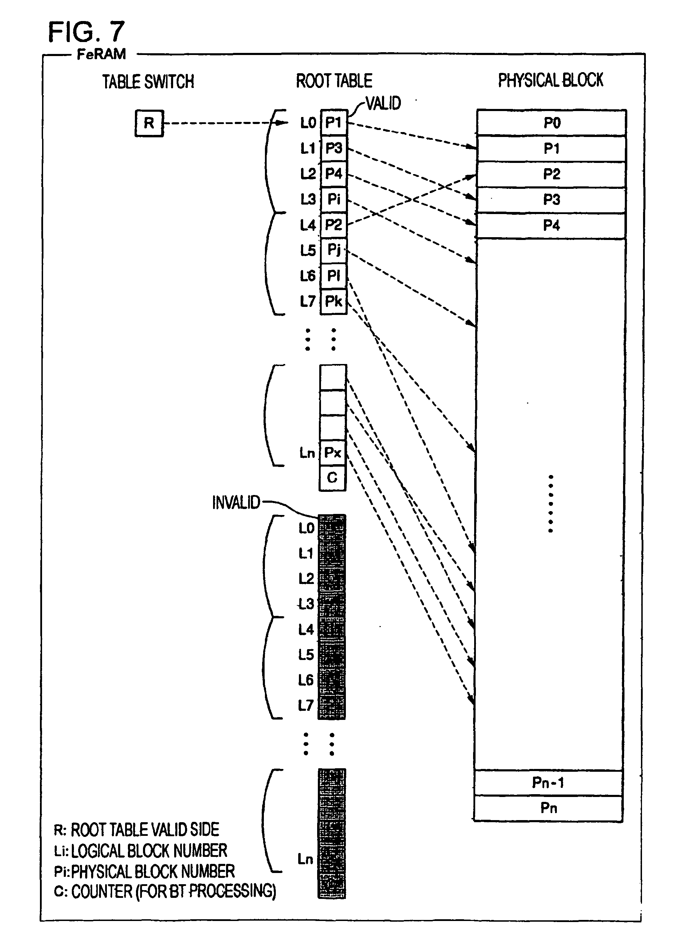

### Data Structure (Fig. 7)

Fig. 7 shows a data structure of a direct-update file system using an FeRAM.

A management table of the FeRAM includes only a root table, as shown in Fig. 7. A root table includes a correspondence list of logical blocks (Li) and physical blocks (Pi) and a counter C for broken transaction. The root table is duplexed to form a duplexed root table set. The FeRAM also includes a table switch (R) indicating which table of the root table set is valid or invalid.

In the case of FeRAM, since writing is performed in units of bytes, it is not necessary to perform writing for each page (segment). Thus, segment tables can be deleted from the data structure. Since no segment table is used, it is not necessary to perform rewriting of a non-updated portion of a segment table with the same data. Thus, the number of writing times of the memory is reduced. In addition, since it is not necessary to control a plurality of segment tables, related processing can be eliminated.

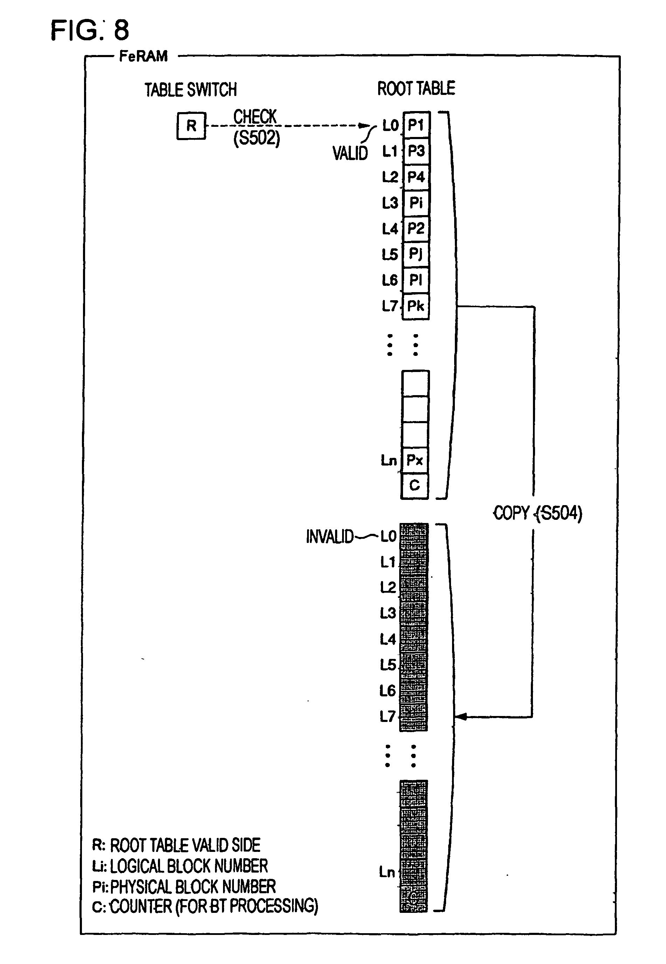

### Startup Process (Fig. 8)

Fig. 8 is an explanatory diagram showing a startup process.

In the startup process, a management table valid side in the FeRAM is copied to a management table invalid side in the FeRAM. Since only the valid side is accessed in a data reading process, the copying of the management table valid side may be performed immediately before the data writing process.

As shown in Fig. 8, a root table valid side in the FeRAM is checked in accordance with the table switch (step S502). Then, the root table valid side (FeRAM) is copied to the root table invalid side (FeRAM) (step S504).

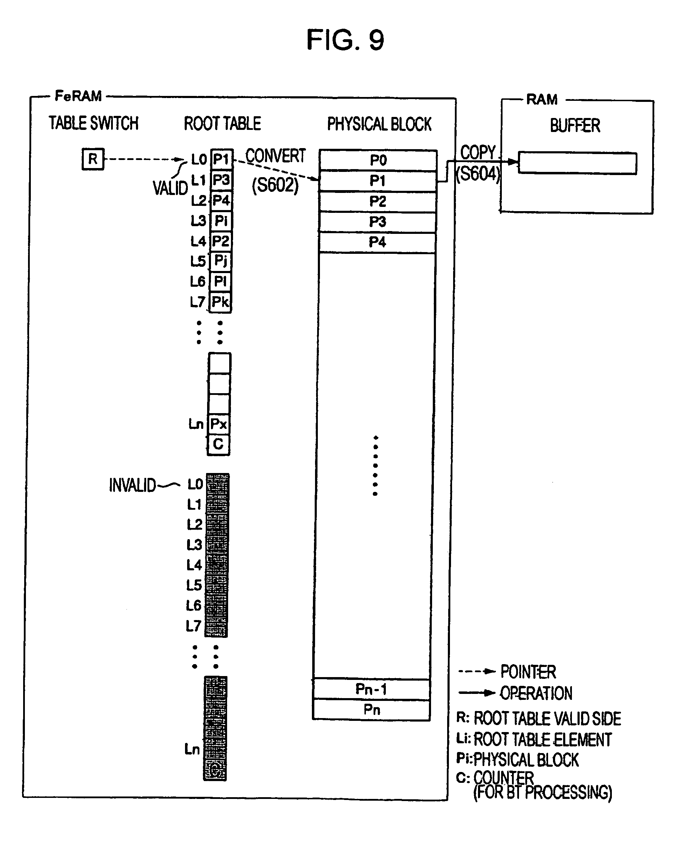

### Data Reading Process (Fig. 9)

In the data reading process, the position of designated data is acquired from the root table valid side in the FeRAM, and the data is copied from a physical block (FeRAM) to a buffer (RAM).

As shown in Fig. 9, a designated logical block number is converted into a physical block number in accordance with information in the root table valid side, as shown in Fig. 9 (step S602). Then, data is copied from a physical block in the FeRAM corresponding to the physical block number to a buffer in the RAM (step S604).

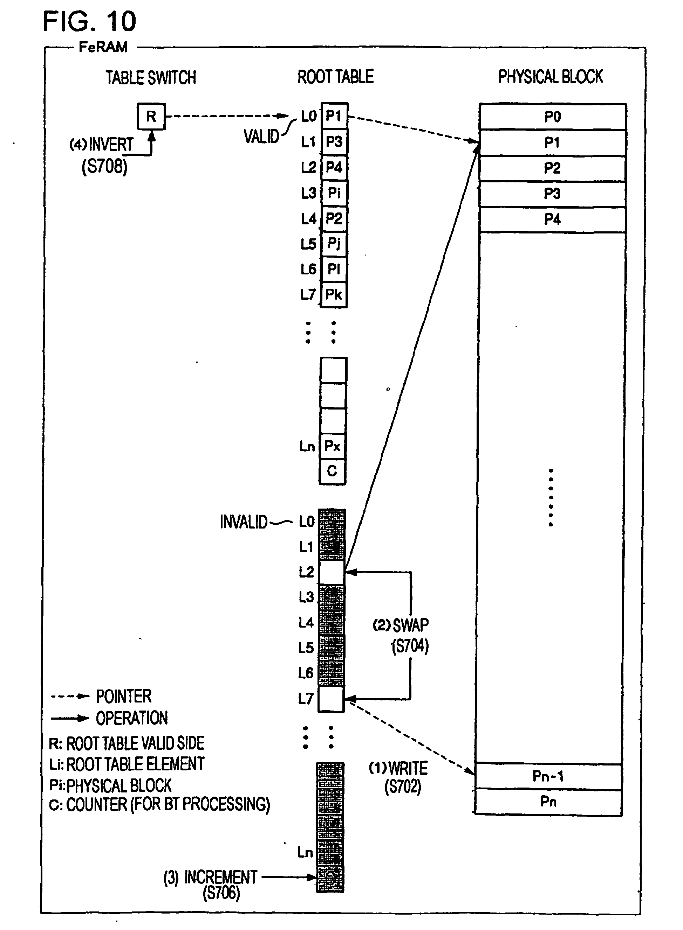

### Data Writing Process (Fig. 10)

In the data writing process, the position of designated data is acquired from the root table invalid side in the FeRAM, and the root table invalid side in the FeRAM is updated so as to indicate the position at which new data is stored. Finally, the table switch in the FeRAM is updated.

As shown in Fig. 10, the designated data is written to a writing buffer (Pn-1 in Fig. 10) in the FeRAM (step S702), as shown in Fig. 10. Then, in the root table invalid side in the FeRAM, an element (L7) indicating the position of the writing buffer is swapped for an element (L2) indicating the position of data to be written (step S704). The counter in the root table invalid side in the FeRAM is incremented (step S706). Finally, the table switch is inverted (step S708). Thus, switching between the valid side and the invalid side is achieved.

Since the final writing to the FeRAM is performed using the table switch, a plurality of pieces of data can be updated at the same time. When a plurality of pieces of data are updated, processing in the writing buffer and the root table invalid side (steps S702 to S706) is repeatedly performed.

As described above, according to the foregoing embodiment, since direct rewriting can be performed in units of bytes, it is not necessary to perform control in units of pages, thus achieving a simplified data structure. In addition, since data in an FeRAM is directly rewritable, at the time of update, instead copying to a RAM, copying to an invalid side of the FeRAM, which has been subjected to duplexing, is performed. Thus, the amount of use of the RAM can be reduced. Furthermore, since a simplified data structure is achieved and copying from the RAM to the FeRAM at the time of data update is unnecessary, the time necessary for the data writing process can be reduced.

Although an IC chip, a data reading method, and a data writing method according to the foregoing embodiment has been described with reference to the drawings, the present invention is not limited to the foregoing embodiment. It is obvious that various changes and modifications made within the technical scope described in the claims can be conceived by those skilled in the art. Thus, it should be understood that various changes and modification made without departing from the technical scope described in the claims fall within the technical scope of the present invention.

For example, although a case where an FeRAM, which is as an example of a nonvolatile memory capable of performing rewriting in units of bytes without necessity of data deletion in units of pages, is used has been described in the foregoing embodiment, the present invention is not limited to the case where an FeRAM is used. Any type of nonvolatile memory (including nonvolatile memories that may be developed in the future) capable of performing rewriting in units of bytes without necessity of data deletion in units of pages can be used.

It should be understood by those skilled in the art that various modifications, combinations, sub-combinations and alterations may occur depending on design requirements and other factors insofar as they are within the scope of the appended claims or the equivalents thereof.

In so far as the embodiments of the invention described above are implemented, at least in part, using software- controlled data processing apparatus, it will be appreciated that a computer program providing such software control and a transmission, storage or other medium by which such a computer program is provided are envisaged as aspects of the present invention.

## Claims

1. An integrated circuit chip (110) comprising:
a memory (112) storing a duplexed data set and capable of data rewriting,
wherein the memory is a nonvolatile memory capable of performing data rewriting in units of bytes without necessity of data deletion in units of pages, and
**characterised in that** the nonvolatile memory has a data structure including:
a duplexed root table set, each root table of the duplexed root table set holding information on the correspondence between a logical block (Li) and a physical block (Pi) and a counter (c) for broken transaction; and
a table switch indicating which root table of the duplexed root table set is valid or invalid.

2. The integrated circuit chip according to Claim 1,
wherein the nonvolatile memory is a ferroelectric random access memory.

3. A data reading method for reading data from an integrated circuit chip according to claim 1 comprising the steps of:
starting up the integrated circuit chip;
acquiring from the valid side of the duplexed root table set stored in the nonvolatile memory the position of data designated to be read and copying the acquired data to a buffer in the volatile memory; and reading the data from the volatile memory.

4. The data reading method according to Claim 3,
wherein the step of starting up the integrated circuit chip includes the steps of:
checking a valid side of the duplexed root table set using the table switch; and
copying information on the physical block corresponding to the logical block from the valid side to the invalid side of the duplexed root table set.

5. The data reading method according to Claim 3,
wherein the nonvolatile memory is a ferroelectric random access memory.

6. A data writing method for writing data to an integrated circuit chip according to claim 1 comprising the steps of:
starting up the integrated circuit chip;
acquiring from the invalid side of the duplexed root table set stored in the nonvolatile memory the position of data designated to be written and updating the invalid side of the duplexed root table set so as to indicate the position at which the new data is stored; and
inverting the table switch to perform switching between the valid side and the invalid side of the duplexed root table set.

7. The data writing method according to Claim 6,
wherein the step of starting up the integrated circuit chip includes the steps of:
checking a valid side of the duplexed root table set using the table switch; and
copying information on the physical block corresponding to the logical block from the valid side to the invalid side of the duplexed root table set.

8. The data writing method according to Claim 6,
wherein the nonvolatile memory is a ferroelectric random access memory.

## Patentansprüche

1. Chip für eine integrierte Schaltung (110), welcher umfasst:
einen Speicher (112), der einen Duplexdatensatz speichert und in der Lage ist, Daten umzuschreiben,
wobei der Speicher ein nichtflüchtiger Speicher ist, der in der Lage ist, Datenumschreibung in Einheiten von Bytes ohne Notwendigkeit von Datenlöschung in Einheiten von Seiten durchzuführen, und
**dadurch gekennzeichnet, dass** der nichtflüchtige Speicher eine Datenstruktur hat, welche aufweist:
einen Duplexverzeichnis-Tabellensatz, wobei jede Verzeichnistabelle des Duplexverzeichnis-Datensatzes Information über die Korrespondenz zwischen einem logischen Block (Li) und einem physischen Block (Pi) und einem Zähler (c) für unterbrochene Transaktion hält; und
einen Tabellenschalter, der zeigt, welche Verzeichnistabelle des Duplexverzeichnis-Tabellensatzes gültig ist oder nicht gültig ist.

2. Chip für eine integrierte Schaltung nach Anspruch 1, wobei der nichtflüchtige Speicher ein ferro-elektrischer Zufallszugriffsspeicher ist.

3. Datenleseverfahren zum Lesen von Daten von einem Chip für eine integrierte Schaltung nach Anspruch 1, welches folgende Schritte umfasst:
Starten des Chips für die integrierte Schaltung;
Erwerben von der gültigen Seite des Duplexverzeichnis-Tabellensatzes, welche im nichtflüchtigen Speicher gespeichert ist, der Position von Daten, die dazu bestimmt sind, gelesen zu werden, und Kopieren der erworbenen Daten auf einen Puffer im flüchtigen Speicher; und
Lesen der Daten vom flüchtigen Speicher.

4. Datenleseverfahren nach Anspruch 3, wobei der Schritt zum Starten des Chips für die integrierte Schaltung folgende Schritte aufweist:
Prüfen einer gültigen Seite des Duplexverzeichnis-Tabellensatzes unter Verwendung des Tabellenschalters; und
Kopieren von Information auf den physischen Block entsprechend dem logischen Block von der gültigen Seite auf die nichtgültige Seite des Duplexverzeichnis-Tabellensatzes.

5. Datenleseverfahren nach Anspruch 3, wobei der nichtflüchtige Speicher ein ferro-elektrischer Zufallszugriffsspeicher ist.

6. Datenschreibverfahren zum Schreiben von Daten auf einen Chip für eine integrierte Schaltung nach Anspruch 1, welches folgende Schritte umfasst:
Inbetriebnehmen des Chips für die integrierte Schaltung;
Erwerben von der nichtgültigen Seite des Duplexverzeichnis-Tabellensatzes, welcher im nichtflüchtigen Speicher gespeichert ist, der Position von Daten, die dazu bestimmt sind, umgeschrieben zu werden, und Aktualisieren der nichtgültigen Seite des Duplexverzeichnis-Tabellensatzes, um so die Position zu zeigen, bei der die neuen Daten gespeichert sind; und
Invertieren des Tabellenschalters, um Schalten zwischen der gültigen Seite und der nichtgültigen Seite des Duplexverzeichnis-Tabellensatzes durchzuführen.

7. Datenschreibverfahren nach Anspruch 6, wobei der Schritt zum Inbetreibnehmen des Chips für die integrierte Schaltung folgende Schritte aufweist:
Prüfen einer gültigen Seite des Duplexverzeichnis-Tabellensatzes unter Verwendung des Tabellenschalters; und
Kopieren von Information auf den physischen Block entsprechend dem logischen Block von der gültigen Seite auf die nichtgültige Seite des Duplexverzeichnis-Tabellensatzes.

8. Datenschreibverfahren nach Anspruch 6, wobei der nichtflüchtige Speicher ein ferro-elektrischer Zufallszugriffsspeicher ist.

## Revendications

1. Puce de circuit intégré (110) comprenant :
une mémoire (112) mémorisant un ensemble de données dupliquées et pouvant faire l'objet d'une réécriture de données,
dans laquelle la mémoire est une mémoire non volatile pouvant faire l'objet d'une réécriture de données par unités d'octets sans nécessiter d'effacement de données par unités de pages, et
**caractérisée en ce que** la mémoire non volatile a une structure de données comprenant :
un ensemble de tables de base dupliquées, chaque table de base de l'ensemble de tables de base dupliquées contenant des informations concernant la correspondance entre un bloc logique (Li) et un bloc physique (Pi) et un compteur (c) pour une transaction interrompue ; et
un commutateur de table indiquant quelle table de base de l'ensemble de tables de base dupliquées est valide ou non valide.

2. Puce de circuit intégré selon la revendication 1. dans laquelle la mémoire non volatile est une mémoire à accès aléatoire ferroélectrique.

3. Procédé de lecture de données pour lire des données dans une puce de circuit intégré selon la revendication 1. ledit circuit intégré comprenant en outre une mémoire volatile, ledit procédé comprenant les étapes consistant à :
démarrer la puce de circuit intégré ;
acquérir, à partir du côté valide de l'ensemble de tables de base dupliquées mémorisé dans la mémoire non volatile, la position de données désignées à lire et copier les données acquises dans une mémoire tampon dans la mémoire volatile ; et
lire les données dans la mémoire volatile.

4. Procédé de lecture de données selon la revendication 3, dans lequel l'étape de démarrage de la puce de circuit intégré comprend les étapes consistant à :
vérifier un côté valide de l'ensemble de tables de base dupliquées en utilisant le commutateur de table : et
copier les informations concernant le bloc physique correspondant au bloc logique du côté valide vers le côté non valide de l'ensemble de tables de base dupliquées.

5. Procédé de lecture de données selon la revendication 3, dans lequel la mémoire non volatile est une mémoire à accès aléatoire ferroélectrique.

6. Procédé d'écriture de données pour écrire des données dans une puce de circuit intégré selon la revendication 1, comprenant les étapes consistant à :
démarrer la puce de circuit intégré ;
acquérir, à partir du côté non valide de l'ensemble de tables de base dupliquées mémorisé dans la mémoire non volatile, la position de données désignées à écrire et mettre à jour le côté non valide de l'ensemble de tables de base dupliquées de manière à indiquer la position à laquelle les nouvelles données sont mémorisées ; et
inverser le commutateur de table pour effectuer une commutation entre le côté valide et le côté non valide de l'ensemble de tables de base dupliquées.

7. Procédé d'écriture de données selon la revendication 6, dans lequel l'étape de démarrage de la puce de circuit intégré comprend les étapes consistant à :
vérifier un côté valide de l'ensemble de tables de base dupliquées en utilisant le commutateur de table ; et
copier les informations concernant le bloc physique correspondant au bloc logique du côté valide vers le côté non valide de l'ensemble de tables de base dupliquées.

8. Procédé d'écriture de données selon la revendication 6, dans lequel la mémoire non volatile est une mémoire à accès aléatoire ferroélectrique.
